# EUROPEAN PATENT APPLICATION

(11) **EP 4 660 886 A1**
(43) Date of publication of application: **10.12.2025**
(21) Application number: 24180297.4
(22) Date of filing: 05.06.2024
(51) Int. Cl.: G06N 3/088

(54) **METHOD FOR MONITORING A PREDICTION ERROR DURING THE INFERENCE OF A MACHINE LEARNING MODEL**

(71) Applicant: SCHNEIDER ELECTRIC INDUSTRIES SAS, 92500 Rueil-Malmaison (FR)
(72) Inventor: MORAND, Denis, 06390 Châteuneuf-Villevieille (FR)
(74) Representative: Plasseraud IP

(57) **Abstract**

The present document proposes a method for monitoring a prediction error during the inference of an application machine learning model providing predictions based on at least one actual time-series signal from an actual sensor, said method comprising:
(a) predicting (S1) an expected time-series signal from the actual time-series signal,
(b) calculating (S2) an error based on the expected signal and the actual signal,
(c) determining (S3) the stationarity of said error,
(d) determining (S4) the evolution of said stationarity.

## Description

### Technical Field

The present disclosure relates to a method for monitoring a prediction error during the inference of a machine learning model.

### Prior art

Ensuring the reliability and efficiency of industrial machinery is a critical concern across various sectors, with a particular emphasis on optimizing operations through predictive analytics. Traditional monitoring techniques, which typically involve periodic assessments or threshold-based alerts, might not fully capture the dynamic nature of industrial processes. These conventional methods are limited in their ability to predict complex scenarios, such as changes in patterns or operational inefficiencies, potentially leading to errors in their prediction, unplanned downtime or costly repairs.

Advancements in data analysis, especially the adoption of machine learning prediction models, have introduced significant potential for enhancing predictive capabilities for a wide range of service requirements, including electrical consumption patterns, operational efficiencies, and component degradation, for example.

Machine learning models can perform predictions on equipment behavior and performance over extended periods, thereby enabling process optimization or other operational parameters adaptations.

However, machine learning applications face challenges in maintaining accuracy in the face of environmental changes and shifts in data distributions, a phenomenon known as data distribution drift. These challenges are particularly pronounced in resource-constrained environments, such as edge computing devices, where traditional retraining methods may not be viable. There is a need to find solutions that can dynamically adapt to these changes, ensuring high predictive performance without imposing undue demands on system resources.

The lifecycle of machine learning applications, characterized by training, testing, deployment, operation, monitoring, and updating, presents unique challenges, particularly in the monitoring phase. Monitoring is complicated by the predictive nature of machine learning outputs, which inherently carry uncertainty. This uncertainty is a significant concern when environmental factors change, affecting the relevance of the training data compared to live operational data. If the live data drifts too far from the training data, the model's predictions could become inaccurate, potentially leading to inefficiencies or operational failures.

Existing solutions often rely on periodic retraining to address data drift, but this approach has limitations, especially in environments with constrained connectivity or computational resources. Moreover, frequent retraining might lead to model forgetting, where the algorithm loses its ability to make accurate predictions based on the initial training set. Additionally, current methods for detecting drift, which often require storing historical data for comparison or human feedback, are not always feasible, more particularly in autonomous or edge computing scenarios.

The present document proposes a method that overcome this limitation.

### Summary

To this aim, the present document proposes a method for monitoring a prediction error during the inference of an application machine learning model providing predictions based on at least one actual time-series signal from an actual sensor, said method comprising:
(a) predicting an expected time-series signal from the actual time-series signal,
(b) calculating an error based on the expected signal and the actual signal,
(c) determining the stationarity of said error,
(d) determining the evolution of said stationarity.

In the context of machine learning, inference refers to the phase where a trained machine learning model, called here application model, is used to make predictions or decisions based on new input data. It computes the probability of outputs given inputs without further adjusting the model's parameters, and it is distinct from the training phase where the model learns from historical data.

Time series data is a type of data that is collected over time, where the order of the data points or values is important, and each value is associated with a specific time stamp. In other words, time series data is a sequence of observations that are collected at regular time intervals.

The time-series signal could represent various types of measurements, such as temperature, vibration, or any other metric that changes over time and is used as input for predictive models.

An actual sensor would refer to a real physical device or instrument that measures or detects a real or actual physical quantity and converts it into a signal.

An actual time-series signal refers to a real or live signal captured by said sensor.

By predicting an expected time-series signal from an actual time-series signal and calculating an error based on the expected and actual signals, the method enables real-time monitoring of the performance of the application machine learning model during its operational or inference phase. This allows for the detection of discrepancies between expected and observed sensor data, facilitating timely interventions, for example retraining of the machine learning model.

Determining the stationarity of the calculated error provides insight into the consistency of the application model's performance over time. If the error remains stationary, it suggests that the model's predictions are stable and reliable. Conversely, non-stationary errors may indicate a drift in the application model's accuracy, signaling a potential need for model retraining or adjustment.

The step of determining the evolution of the stationarity of the error further enhances the method's capability to track changes in the application model's performance. This step allows for the differentiation between temporary fluctuations and sustained changes in error behavior, which is critical for making informed decisions about maintaining or updating said machine learning model.

Various error functions, such as L1 norm, L2 norm, and others, can be employed to calculate the error between the predicted signal and the actual signal.

The L1 norm for two scalars a and b is the absolute difference between them.

The L2 norm for two scalars a and b is the square root of the sum of the squares of their differences.

Expected time-series signal may be predicted from the actual time-series signal using a masked autoencoder model.

A Masked Autoencoder (MAE) [B1] enhances the traditional autoencoder architecture for unsupervised learning, aiming to encode data into a compact representation without reliance on labels. Its defining characteristic is the incorporation of masking, where parts of the input data are intentionally obscured or "masked" before processing. This method compels the autoencoder to fill in the gaps, fostering the development of more robust and comprehensive data representations.

The MAE architecture is bifurcated into two principal components: the encoder and the decoder. The encoder is tasked with converting the partially masked input into a condensed latent representation, focusing on capturing the essence of the visible data. Conversely, the decoder works to reconstruct the original, unmasked input from this latent representation, effectively guessing the obscured parts initially masked by the encoder. This process begins with masking, wherein a random selection of the input data is obscured, a step that varies in degree but often involves a significant portion of the data to enhance the model's learning from limited information.

Following the initial masking, the encoder processes the altered input, deriving a dense latent representation despite the incomplete data, by inferring the missing information from the context of the unmasked data. The decoder then attempts to rebuild the entire input, including the previously masked sections, relying on the latent representation. This reconstruction phase challenges the model to leverage the learned features and visible data context to accurately predict the obscured information.

The training of the model centers on reducing the discrepancy between the original input and its reconstructed counterpart, with a particular focus on the accuracy of the predictions for the masked portions. The choice of loss function, such as Mean Squared Error for continuous data or Cross-Entropy for categorical data, may be tailored to the data type.

In the context of the patent application, the MAE is used to monitor the similarity of live data with historical data. During training, a small percentage of historical data frames are masked and the model learns to reconstruct these frames. During inference, the model predicts live data and the difference between the live data and the predicted data is monitored to determine if there is a drift.

The masked autoencoder's ability to focus on reconstructing missing or masked parts of the input signal contributes to a more precise error calculation, for the subsequent steps of stationarity determination and drift detection.

The use of a masked autoencoder model specifically caters to the constraints of edge computing devices by minimizing the need for extensive computational resources. This is particularly advantageous for applications where memory and processing power are limited, such as in embedded systems or loT devices. The masked autoencoder's architecture is designed to handle the high-dimensional data typically generated by sensors, effectively compressing the information into a more manageable form without the necessity of storing large volumes of historical sensor data.

The expected time-series signal may also be predicted from the actual time-series signal using another machine learning model, for example a variational autoencoder.

A variational autoencoder (VAE) [B2] enhances the traditional autoencoder architecture by incorporting variational inference, where the latent variables are modeled as distributions rather than fixed values. This approach encourages the autoencoder to learn a more flexible and expressive latent space, enabling the generation of new data samples that resemble the original data.

The VAE architecture is divided into two principal components: the encoder and the decoder. The encoder maps the input data to a probabilistic latent space, producing parameters for the mean and variance of the latent variable distributions. This probabilistic mapping allows the model to account for uncertainty and variability in the data. The decoder then reconstructs the original input from samples drawn from these latent distributions, effectively generating new data points based on the learned latent representations. This process involves sampling, where the latent variables are drawn from the distributions parameterized by the encoder, a step that introduces stochasticity and enhances the model's generative capabilities.

During training, the encoder processes the input data, producing a distribution over the latent space that captures the essence of the data. The decoder then attempts to reconstruct the input from samples drawn from this distribution. The training objective is to minimize the difference between the original input and its reconstructed counterpart while also regularizing the latent space to adhere to a prior distribution, typically a standard normal distribution. This regularization encourages the model to learn meaningful and disentangled features, facilitating better generalization and data generation.

The training process focuses on optimizing a loss function that balances reconstruction accuracy with the regularization of the latent space. This loss function typically includes a reconstruction term, such as Mean Squared Error for continuous data, and a regularization term, such as the Kullback-Leibler divergence, to enforce the probabilistic constraints on the latent space.

In the context of practical applications, the VAE can be used to generate new, similar data, perform data imputation, and enhance anomaly detection by modeling the distribution of normal data and identifying deviations. The probabilistic nature of the VAE's latent space enables it to capture complex data distributions and generate diverse data samples, making it suitable for a wide range of tasks in machine learning and data analysis.

The use of a VAE model specifically caters to applications requiring the generation of realistic data samples and the handling of high-dimensional data in a compact and expressive form. This is particularly advantageous for tasks involving image generation, text synthesis, and other applications where understanding and generating complex data distributions is crucial. The VAE's architecture is designed to handle the high variability in data, effectively learning a rich and flexible representation that can be leveraged for various downstream tasks.

Stationarity is a concept in time series analysis that describes a situation where the statistical properties of a process generating a time series do not change over time. This means that the series remains consistent through its central tendency (mean), variability (variance), and autocorrelation (the linear dependence between elements of the series at different times) over time.

The stationarity of said error may be determined using the Augmented Dickey-Fuller method.

The Augmented Dickey-Fuller (ADF) [B3] method is a statistical test used to determine whether a given time series is stationary or not. The presence of a unit root in a time series signals that the series is non-stationary, meaning its properties can change overtime, which can complicate analysis and forecasting.

The ADF test addresses this by explicitly testing for the presence of a unit root in the time series data. It builds on the Dickey-Fuller test by including lagged differences of the series in the regression equation, enhancing the test's ability to accommodate series with autoregressive structures. Essentially, the test regresses the difference of the series against its lagged values and a constant (and possibly a trend), and then examines the coefficient of the lagged level of the series to determine if it is significantly different from zero. A significantly negative coefficient suggests the rejection of the null hypothesis of a unit root, implying that the time series is stationary.

The ability to include lagged differences in the regression equation allows the ADF test to provide more reliable results in a broader range of scenarios compared to the original Dickey-Fuller test.

The evolution of said stationarity may be determined using a statistical model.

Said statistical model may use one of the following methods: Drift Detection Method, Early Drift Detection Method, Hierarchical Drift Detection Method, Hierarchical Drift Detection Method with W-test.

Drift detection methods address the challenge of detecting changes in the underlying data distribution over time, known as concept drift. These methods aim to identify when the model's predictive performance degrades due to changes in the environment or data generation process.

The Drift Detection Method (DDM) monitors the model's error rate as data streams in, looking for significant increases that suggest a change in the data distribution. When the error rate crosses a predefined threshold, indicating a statistically significant increase, DDM flags a drift. This simple yet effective approach allows for timely updates to the predictive model to adapt to new data patterns.

Building on DDM, the Early Drift Detection Method (EDDM) aims to detect drifts earlier by focusing on the distance between consecutive errors instead of the error rate itself. EDDM posits that as concept drift begins, the pattern of errors changes before the error rate increases significantly. By detecting subtle changes in the distribution of errors, EDDM can trigger alerts for potential drifts earlier than DDM, allowing for more proactive model adjustments.

The Hierarchical Drift Detection Method (HDDM) introduces a more nuanced approach by employing multiple levels of drift detection. It operates by creating a hierarchy of drift detectors, each monitoring at different granularities or aspects of the data stream. This hierarchical structure enables the detection of both abrupt and gradual drifts more effectively by analyzing the data stream at multiple resolutions. HDDM can differentiate between short-term fluctuations and true, long-term changes in the data distribution, providing a more detailed understanding of the nature of the drift.

An extension of HDDM incorporates the W-test, known as HDDM-W, to enhance the detection mechanism further. The W-test is a statistical test used to compare variances in distributions, and its integration into HDDM allows for a more sophisticated analysis of changes in the data stream. By applying the W-test, HDDM-W can more accurately determine whether observed changes are statistically significant, reducing false alarms and improving the reliability of drift detection. This method is particularly useful in environments where data characteristics can change subtly and gradually, ensuring that the predictive model remains well-tuned to the current data distribution.

The actual sensor time-series signal is a signal from at least one of the following sensors:
- a temperature sensor, for example, a thermocouple, a thermistor, a Resistance Temperature Detector (RTD), an infrared sensor,
- a pressure sensor, for example, a piezoelectric sensor, a capacitive sensor, a Hall effect sensor, a manometer, a barometer,
- a humidity sensor, for example, a hygrometer, a relative humidity sensor, an absolute humidity sensor,
- a force sensor, for example, a strain gauge, a piezoelectric force sensor, a load cell,
- a displacement or position sensor, for example, an encoder, a potentiometer, a Linear Variable Differential Transformer (LVDT), an ultrasonic sensor, a magnetic sensor,
- a speed or acceleration sensor, for example, an accelerometer, a gyroscope, a Doppler radar, a Hall effect speed sensor,
- a level sensor, for example, a float sensor, an ultrasonic level sensor, a capacitive level sensor, a radar level sensor,
- a flow sensor, for example, a mass flow meter, a volumetric flow meter, an ultrasonic flow meter, an electromagnetic flow meter,
- a light or radiation sensor, for example, a photodiode, a photoresistor, a visible light sensor, a UV sensor, an infrared sensor,
- a gas or air quality sensor, for example, a CO2 detector, a carbon monoxide detector, a smoke detector, an air quality sensor,
- a chemical sensor, for example, an ion selective electrode, a pH sensor, a dissolved oxygen sensor, a specific gas sensor,
- an acoustic sensor, for example, a microphone, a hydrophone,
- a vibration sensor, for example, an accelerometer, a piezoelectric sensor,
- a magnetic sensor, for example, a Hall effect sensor, a magnetometer,

The application machine learning model may be re-trained based on at least one updated actual signal, if the stationarity of said error is unstable.

By retraining an application machine learning model based on updated actual signal when the error is unstable (which characterizes a drift), the method ensures that the model remains accurate and relevant to the current operational conditions. This approach allows for the automatic adjustment of the model in response to changes in the data, which may be due to environmental variations, equipment wear, or other factors that could affect sensor readings. The predefined threshold acts as a trigger for retraining, ensuring that the model is updated only when necessary, thereby optimizing computational resources and avoiding unnecessary retraining cycles.

This method facilitates the maintenance of high prediction accuracy without the need for continuous human intervention, thereby reducing the operational costs associated with manual monitoring and retraining of machine learning models. It also minimizes the risk of "catastrophic forgetting" by preventing excessive retraining, which can cause the model to lose its ability to accurately predict based on the initial training data. The result is a more reliable and autonomous system capable of adapting to evolving conditions in real-time, which is particularly beneficial for edge computing environments with limited resources and connectivity.

A wear rate of an electrical machine, for example an electrical motor or generator, may be determined based on the application machine learning model.

The present document also concerns a computer program comprising instructions for implementing the above-mentioned method, when this program is executed by a processor.

The present document also concerns a non-transitory computer-readable recording medium on which is recorded a program for implementing the above-mentioned method, when said program is executed by a processor.

The present document also concerns a computer device comprising:
- an input interface to receive at least one input time series signal,
- a memory for storing at least instructions of said computer program,
- a processor accessing to the memory for reading the aforesaid instructions and executing then the above-mentioned method,
- an output interface to provide an information concerning the evolution of said stationarity. The device can be any suitable processor-driven device, including, but not limited to, a mobile device or a non-mobile device, for example, a static device. A processor may comprise one or more computing units and may comprise, for example, electronic circuits, quantum, photonic and/or optical calculators. For example, the device may comprise a desktop computer, a laptop computer, a rack-mounted computer, a tablet, a personal digital assistant (PDA) or a wearable wireless device (for example, a bracelet, watch, glasses, ring, cell phone or smartphone) or an Internet of Things (IoT) device.

### Brief description of the drawings

Other features, details and advantages will become apparent from the detailed description below, and from an analysis of the attached drawings, in which:
[Fig. 1] is a schematic diagram illustrating a computer device according to the present document,
[Fig. 2] is a schematic diagram illustrating the method according to the present document.

### Detailed description of the drawings

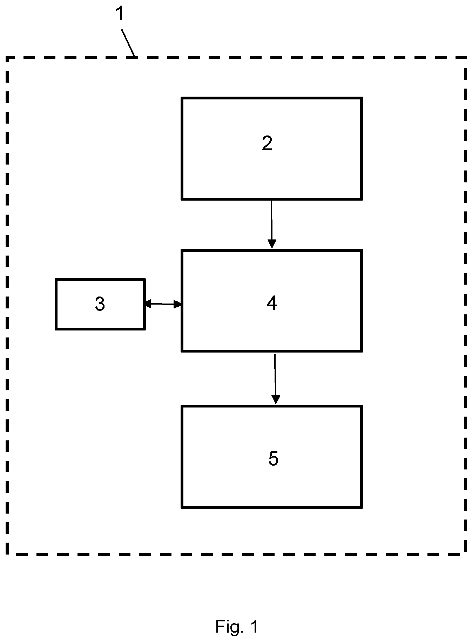

Figure 1 shows a computer device 1 comprising:
- an input interface 2 to receive said at least one time series signals from an actual sensor,
- a memory 3 for storing at least instructions of a computer program and executing a method according to the present document, described below,
- a processor 4 accessing to the memory 3 for reading and executing the aforesaid instructions,
- an output interface 5 to provide an information concerning the evolution of said stationarity.

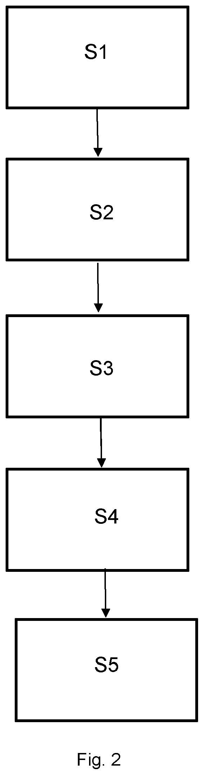

The method according to the present document is shown in Figure 2. Said method aims to monitor a prediction error during the inference of an application machine learning model providing predictions based on at least one actual time-series signal from an actual sensor.

The application machine learning model is for example trained to evaluate the wear rate or the functioning of a machine, for example an electrical machine, such as an electrical motor or generator.

Said sensor is for example a temperature sensor, a pressure sensor, a humidity sensor, a force sensor, a displacement or position sensor, a speed or acceleration sensor, a level sensor, a flow sensor, a light or radiation sensor, a gas or air quality sensor, a chemical sensor, an acoustic sensor, a vibration sensor, or a magnetic sensor.

Said method comprises a first step S1 of predicting an expected time-series signal from the actual time-series signal. Said prediction is made from the actual time-series signal using a masked autoencoder model.

Then, in a second step S2, an error based on the expected signal and the actual signal is calculated. Such error may be calculated by using the L1 or L2 norm, for example.

In a third step S3, the stationarity of said error is determined, for example using the Augmented Dickey-Fuller method.

Then, in a fourth step S4, the evolution of said stationarity is determined using a statistical model, for example through one of the following methods: Drift Detection Method, Early Drift Detection Method, Hierarchical Drift Detection Method, Hierarchical Drift Detection Method with W-test.

The evolution of said stationarity may be evaluated through classes, for example a class indicating that the error is stable, a class indicating that the error may be unstable and a class indicating that the error is drifting.

Alternatively, the evolution of said stationarity may be evaluated through a scalar or a tensor representing said evolution.

The application machine learning model may be re-trained in a fifth step S5, based on at least one updated actual signal, if said error is not stable.

For example, such update may be performed if the stationarity belongs to the above-mentioned class indicating that the error is drifting, or if the scalar representing said stationarity is below a predefined threshold for example.

### Bibliography

[B1] Masked Autoencoders Are Scalable Vision Learners, Kaiming He, Xinlei Chen, Saining Xie, Yanghao Li, Piotr Dollár, Ross Girshick, arXiv:2111.06377 (https://arxiv.org/abs/2111.06377)
[B2] Diederik P. Kingma et Max Welling, « Auto-Encoding Variational Bayes », arXiv:1312.6114,
[B3] Mushtaq, Rizwan, Augmented Dickey Fuller Test (August 17, 2011) (https://ssrn.com/abstract=1911068 or http://dx.doi.org/10.2139/ssrn.1911068)

## Claims

1. Method for monitoring a prediction error during the inference of an application machine learning model providing predictions based on at least one actual time-series signal from an actual sensor, said method comprising:
(a) predicting (S1) an expected time-series signal from the actual time-series signal,
(b) calculating (S2) an error based on the expected signal and the actual signal,
(c) determining (S3) the stationarity of said error,
(d) determining (S4) the evolution of said stationarity.

2. Method according to the preceding claim, wherein the expected time-series signal is predicted from the actual time-series signal using a masked autoencoder model or a variational autoencoder model.

3. Method according to any of the preceding claims, wherein the stationarity of said error is determined using the Augmented Dickey-Fuller method.

4. Method according to any of the preceding claims, wherein the evolution of said stationarity is determined using a statistical model.

5. Method according to the preceding claim, wherein said statistical model uses one of the following methods: Drift Detection Method, Early Drift Detection Method, Hierarchical Drift Detection Method, Hierarchical Drift Detection Method with W-test.

6. Method according to any of the preceding claims, wherein the actual sensor time-series signal is a signal from at least one of the following sensors:
- a temperature sensor,
- a pressure sensor,
- a humidity sensor,
- a force sensor,
- a displacement and position sensor,
- a speed and acceleration sensor,
- a level sensor,
- a flow sensor,
- a light and radiation sensor,
- a gas and air quality sensor,
- a chemical sensor,
- an acoustic sensor,
- a vibration sensor,
- a magnetic sensor.

7. Method according to any of the preceding claims, wherein the application machine learning model is re-trained (S7) based on at least one updated actual signal, if the stationarity of said error is unstable.

8. Method according to any of the preceding claims, wherein a wear rate of an electrical machine, is determined based on the application machine learning model.

9. Computer program comprising instructions for implementing the method according to one of claims 1 to 8, when this program is executed by a processor.

10. A non-transitory computer-readable recording medium on which is recorded a program for implementing the method according to one of claims 1 to 7, when said program is executed by a processor.

11. Computer device (1) comprising:
- an input interface (2) to receive at least one time series signal,
- a memory (3) for storing at least instructions of a computer program according to claim 9,
- a processor (4) accessing to the memory (3) for reading the aforesaid instructions and executing then the method according to one of claims 1 to 8,
- an output interface (5) to provide an information concerning the evolution of said stationarity.
